# EUROPEAN PATENT SPECIFICATION

(11) **EP 1 219 032 B1**
(45) Date of publication and mention of the grant of the patent: **09.05.2007**
(21) Application number: 00952110.5
(22) Date of filing: 04.08.2000
(51) Int. Cl.: H03L 7/085

(54) **METHOD AND ARRANGEMENT FOR LOCKING A CONTROL VOLTAGE TO A VOLTAGE-CONTROLLED OSCILLATOR**
VERFAHREN UND ANORDNUNG ZUR VERRIGELUNG EINER EINEM SPANNUNGSGESTEUERTEN OSZILLATOR ZUGEFÜHRTEN STEUERSPANNUNG
TECHNIQUE ET DISPOSITIF DE VERROUILLAGE D'UNE TENSION DE COMMANDE ALIMENTANT UN OSCILLATEUR COMMANDE EN TENSION

(30) Priority: 07.09.1999 SE 9903157
(43) Date of publication of application: 03.07.2002
(73) Proprietor: Infineon Technologies AG, 81669 München (DE)
(72) Inventor: WESTBERG, David, S-746 38 BALSTA (SE); SVALÄNGE, Pär, S-112 63 Stockholm (SE)
(74) Representative: Karlsson, Leif Karl Gunnar
(86) International application number: PCT/SE2000/001546
(87) International publication number: WO 2001/018968

(56) References cited:
- US-A- 5 339 049
- US-A- 5 604 465
- US-A- 5 870 003

## Description

### TECHNICAL FIELD

The invention relates generally to voltage-controlled oscillators and more specifically a method and an arrangement for locking a control voltage to a voltage-controlled oscillator.

### BACKGROUND OF THE INVENTION

In a frequency-hopping radio where a voltage-controlled oscillator (VCO), connected in a phase-locked loop with a phase detector and a loop filter, is directly modulated, the loop filter has a relatively large bandwidth to ensure that a frequency hop can be made quickly enough at repetitive channel changes. In order for the phase-locked loop not to compensate away the greater part of the modulation, the loop has to be opened during transmission. This is controlled by a signal to the phase detector, which opens the loop and turns off current generators that control the control voltage to the VCO.

Thus, when the loop is opened, there is no feedback to the VCO, but its frequency is determined by the output voltage of the loop filter. This output voltage is determined by charges stored in capacitors in the loop filter.

In theory, this works well, but in practice, there are high requirements on the quality of the capacitors, leak currents in the current generators when turned off, leak currents in varactor diodes in the VCO, etc.

One major problem is the memory effect of the capacitors that causes them more or less to return to the voltage they had before. If a frequency hop has been made e.g. from low frequency (low voltage) to high frequency (high voltage) in order to start transmitting at the latter, the voltage across the capacitors will initially change in the same direction as the old value. This is due to the memory effect of the capacitors when the loop is opened and the current generators are turned off. To compensate for this change, more expensive capacitors with less memory effect have to be used.

Another major problem is leakage in the varactor diodes of the VCO and/or in the current generators. Very small leak currents (100 pA) are enough for the capacitors to be charged or discharged enough for the frequency to drift away. The problem is particularly big at increased temperatures.

We will now present a few publications that presents the state of the art.

Publication US A 5 870 003 discloses a phase locked loop for supplying clock signals having a phase detector receiving an input reference signal, and two feeding charge pumps, generating complementary control signals for a voltage controlled oscillator, such that the oscillator clock output provides a feedback signal for the detector. The phase locked loop circuit further includes a replica biasing circuit for providing a replica bias control voltage to the voltage controlled oscillator.

The voltage control to the VCO is supplied through the charge pump (column 3, lines 38 to 44). The replica bias control voltage is utilized to bias VCO active loads, adjusted to minimize the difference between the feedback voltage and the reference voltage, adjusted to maintain constant swing (column 4, lines 49 to 53).

Publications US A 5 339 049 discloses a frequency divider and multiplier circuits comprising a voltage controlled oscillator, a presteer circuit comprising a frequency comparator, a sampling phase detector circuit comprising a sampler, a pair of pre-scalers for providing frequencies in the divider/multiplier circuits by a determined number D, a programmable divider for dividing one of the frequencies in the divider/multiplier circuits by a selectable N and a summing circuit.

In operation the presteer circuit drives the VCO toward a predetermined frequency. When the VCO reaches the predetermined frequency, the output of the presteer circuit is disabled and the sampling phase detector takes over, locking the VCO to the predetermined desired frequency.

Publication US A 5 604 465 discloses an adaptive self-calibration of a radio tuner. An integrator (410) receives a signal from a phase detector (406), which calculates the phase difference between a reference signal (404) and an output signal (420) from an input-controlled oscillator (ICO) (418). The integrator (410) uses the phase difference to provide an error signal upon a line (412), which constitutes one input to a summer (414). The summer (414) sums the error signal with an analogue steering signal on a line (416) in order to produce a corrected signal to the ICO (418). (Column 4, lines 44 to 67).

The tuner according to US A 5 604 465 also includes a steering circuitry (430) which accomplishes dual purposes: (1) assisting the summer (414) in quickly and accurately providing its output to the ICO (418), and (2) during ongoing operation re-calibrating the output of the summer (414) by adaptively compensating for error that might arise from temperature changes and other factors (column 5, lines 21 to 27).

Specifically an ADC (434) in the steering circuitry (430) samples the error signal (412) which should optimally be zero during ongoing operation of the tuner. If any error is found, a corrected steering signal is calculated and applied to the input line (416) of the summer (414).

The steering circuitry (430) comprises a memory (438) where pre-steering values may be stored for use the next time the same desired tune frequency is selected (column 6, line 58, to column 7, line 3).

The phase detector (406), the summer (414) and the steering circuitry (430) is working continuously during operation of the tuner with the constant use of the reference frequency (402) as an input parameter in order to prevent any drift due to any detected error.

Publication EP 1 047 196 describes a method and a circuit for minimizing glitches in phase locked loops. It describes that due to the asymmetry of the two generators in the charge pump generator it generates glitches and the purpose of the method and circuit according to this publication is to minimize the generation of glitches.

The publication shows that a compensating circuit is connected between the charge pump generator and the filter, and that this compensating circuit comprises a storage element connected in series with a controlled switch.

The purpose of the storage element is to absorb the amount of charge passed through the charge pump generator, thereby accommodating any leakages from the generator or charge build-ups due to dissymmetries on its inside.

In locked condition and in the presence of dissymmetry between the current generators, a filter current will be flowing through the storage element, allowing an amount of charge to build up in this element. At the end of the conduction period of the generators inside the charge pump generator, the charge built-up in the storage element will be nil.

In particular, the storage element comprises a capacitor connected between the output of the charge pump generator and a voltage reference, such as ground. This capacitor should be of limited capacitance not to affect the transfer function of the loop as a whole.

### SUMMARY OF THE INVENTION

The object of the invention is to bring about an improved method and an improved arrangement for locking the control voltage to a VCO.

This is attained in accordance with the invention mainly by generating a copy of the control voltage when the frequency difference between the output frequency of the VCO and a desired frequency is zero, and applying that generated copy of the control voltage as control signal to the VCO to lock its output frequency.

Hereby, the output frequency of the VCO will not drift.

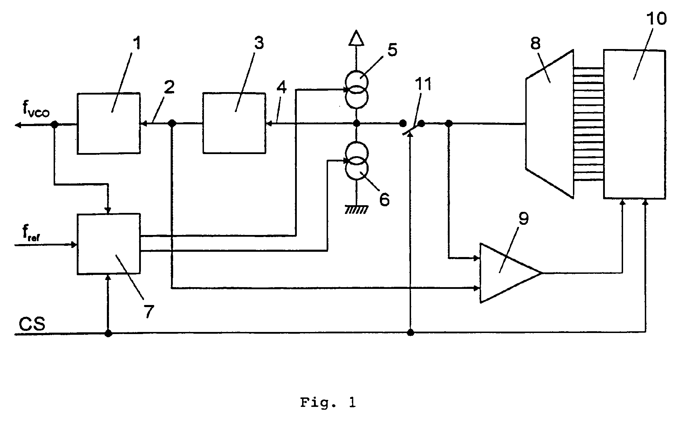

### BRIEF DESCRIPTION OF THE DRAWING

The invention will be described more in detail below with reference to the appended drawing, on which the single Figure is a block diagram of an embodiment of an arrangement in accordance with the invention.

### DESCRIPTION OF THE INVENTION

On the drawing, an arrangement for locking a control voltage of a VCO 1 in a frequency-hopping radio is illustrated. The rest of the radio is not shown.

The VCO 1 is connected in a phase-locked loop and has a control input 2 connected to an output of a loop filter 3, which in a manner known per se comprises capacitors and resistors (not shown). The input 4 of the loop filter is connected to current generators 5 and 6, controlled by respective output signals from a phase detector or frequency comparator 7.

The comparator 7 is connected with one input to the output of the VCO 1 and is adapted to compare the output frequency f_{vco} of the VCO 1 with a desired frequency f_{ref}. The desired frequency f_{ref} is obtained in a manner known per se from a control unit (not shown) upon a desired frequency hop.

Upon such a desired frequency hop, an output signal is generated by the comparator 7 in response to any frequency difference between the frequencies f_{vco} and f_{ref}. Depending on whether the frequency difference is positive or negative, the comparator 7 will control one of the current generators 5 and 6 to supply current to the loop filter 3 to control the output frequency of the VCO 1, i.e. f_{vco}, to f_{ref}. The other one of the current generators 5 and 6 will be kept turned off by the comparator 7.

After a certain time, f_{vco} = f_{ref}. Then, there will be no output signal from the comparator 7.

At that time, the phase-locked loop will be opened by a control signal CS from the control unit (not shown) to turn off the comparator 7. Hereby, both current generators 5 and 6 will be turned off by the comparator 7.

As indicated in the introductory portion above, this will cause the output frequency of the VCO 1 to drift.

In accordance with the invention, to eliminate this problem, i.e. to stop the output frequency of the VCO 1 from drifting, an arrangement is provided to generate a copy of the VCO control voltage, at least at the time when f_{vco} = f_{ref}, i.e, when the frequency difference is zero, and to apply that generated copy as control signal to the VCO 1 when the current generators 5 and 6 have been turned off.

In this connection, it should be understood that the copy of the control voltage can be continuously generated.

In the embodiment shown on the drawing, a digital-to-analog converter (DAC) 8 is used to generate the copy of the VCO control voltage.

The inputs of the DAC 8 are connected to outputs of a logic unit 10. The logic unit 10 is connected with one input to the output of a comparator 9. The comparator 9 has one of its inputs connected to the control input 2 of the VCO 1, and its other input connected to the output of the DAC 8. Thus, the logic unit 10 will generate a bit-pattern on the inputs of the DAC 8 until the output signal from the comparator 9 is close to zero, i.e. when the output voltage of the DAC 8 is more or less equal to the VCO control voltage.

Hereby, a copy of the VCO control voltage appears on the output of the DAC 8.

In this connection, it should be mentioned that the copy of the VCO control voltage does not necessarily have to be generated by means of a DAC. Instead, e.g. a sample-and-hold circuit (not shown) can equally well be used. The sample-and-hold circuit would it that case be connected with its input to the output of a comparator, and the comparator would be connected with its inputs to compare the control voltage to the voltage-controlled oscillator with the output voltage of the sample-and-hold circuit.

In the embodiment shown on the drawing, the output of the DAC 8 is connectable to the input 4 of the loop filter 3 via a switch 11 which is closed by the same control signal CS from the control unit (not shown) that turns off the comparator 7 when f_{vco} = f_{ref}, i.e. when the current generators 5 and 6 are turned off as described above.

The radio can now start transmitting at the desired frequency.

At the same time, the control signal CS is supplied to an input of the logic circuit 10 to turn off the logic circuit 10 so that the output signal of the DAC 8 is maintained.

Hereby, the copy of the VCO control voltage, generated by the DAC 8 in the embodiment shown, is applied as control signal to the VCO 1 via the loop filter 3 to lock the output frequency f_{vco} of the VCO 1 in correspondence with the desired frequency f_{ref}.

Since the generated copy of the control voltage to the VCO 1 remains unchanged on the control input 2 to the VCO 1, its output frequency will not drift.

As should be apparent from the above, the problems with frequency drift are eliminated.

## Claims

1. A method of locking a control voltage to avoltage-controlled oscillator (1) in correspondence with a desired frequency (f_{ref}), comprising
- comparing the output frequency (f_{vco}) of the voltage-controlled oscillator (1) with the desired frequency (f_{ref}),
- generating a signal in response to any frequency difference, and
- adjusting the control voltage in response to said generated signal until the frequency difference is zero,
**characterized by**
- generating a copy of the control voltage, at least when said frequency difference is zero, and
- applying said generated copy of the control voltage as control signal to the voltage-controlled oscillator (1) to lock its output frequency, when said frequency difference is zero.

2. The method as claimed in claim 1, **characterized in that** said copy of the control voltage is continuously generated.

3. An arrangement for locking a control voltage to a voltage-controlled oscillator (1) in correspondence with a desired frequency (f_{ref}), comprising
- a comparator (7) for comparing the output frequency (f_{vco}) of the voltage-controlled oscillator (1) with the desired frequency (f_{ref}), and for generating a signal in response to any frequency difference, and
- means (5, 6) for adjusting the control voltage in response to said generated signal until the frequency difference is zero, **characterized by**
- means (8, 9, 10) for generating a copy of the control voltage at least when said frequency difference is zero, and
- means (11) for applying said copy of the control voltage, generated when said frequency difference is zero, as control signal to the voltage-controlled oscillator (1) to lock its output frequency at the desired frequency (f_{ref}).

4. The arrangement as claimed in claim 3, **characterized by** said generating means (8, 9, 10) being adapted to continuously generate said copy of the control voltage.

5. The arrangement as claimed in claim 3 or 4, **characterized in that** said generating means comprises a digital-to-analog converter (8) connected with its input to the output of a comparator (9) via a logic circuit (10), the comparator (9) being connected with its inputs to compare the control voltage to the voltage-controlled oscillator (1) with the output voltage of the digital-to-analog converter (8).

6. The arrangement as claimed in claim 3 or 4, **characterized in that** said generating means comprises a sample-and-hold circuit connected with its input to the output of a comparator, the comparator being connected with its inputs to compare the control voltage to the voltage-controlled oscillator with the output voltage of the sample-and-hold circuit.

## Patentansprüche

1. Verfahren zum Festsetzen einer Regelspannung eines spannungsgeregelten Oszillators (1) entsprechend einer gewünschten Frequenz (f_{ref}), umfassend:
- das Vergleichen der Ausgangsfrequenz (f_{vco}) des spannungsgeregelten Oszillators (1) mit der gewünschten Frequenz (f_{ref}),
- das Erzeugen eines Signals als Antwort auf eine Frequenzdifferenz und
- das Einstellen der Regelspannung als Antwort auf das erzeugte Signal bis die Frequenzdifferenz null ist,
**gekennzeichnet durch**
- das Erzeugen einer Kopie der Regelspannung zumindest dann, wenn die Frequenzdifferenz null beträgt und
- das Anwenden der erzeugten Kopie der Regelspannung als Regelsignal für den spannungsgeregelten Oszillator (1), um dessen Ausgangsfrequenz festzusetzen, wenn die Frequenzdifferenz null beträgt.

2. Verfahren nach Anspruch 1, **dadurch gekennzeichnet, dass** die Kopie der Regelspannung ständig erzeugt wird.

3. Anordnung zum Festsetzen einer Regelspannung eines spannungsgeregelten Oszillators (1) entsprechend einer gewünschten Frequenz (f_{ref}), umfassend:
- einen Vergleicher (7) zum Vergleichen der Ausgangsfrequenz (f_{vco}) des spannungsgeregelten Oszillators (1) mit der gewünschten Frequenz (f_{ref}) und zum Erzeugen eines Signals als Antwort auf eine Frequenzdifferenz und
- Mittel (5, 6) zum Einstellen der Regelspannung als Antwort auf das erzeugte Signal bis die Frequenzdifferenz null ist,
**gekennzeichnet durch**
- Mittel (8, 9, 10) zum Erzeugen einer Kopie der Regelspannung zumindest dann, wenn die Frequenzdifferenz null beträgt und
- Mittel (11) zum Anwenden der Kopie der Regelspannung, die erzeugt wird wenn die Frequenzdifferenz null beträgt, als Regelsignal für den Spannungsgeregelten Oszillator (1) um dessen Ausgangsfrequenz auf die gewünschte Frequenz (f_{ref}) festzusetzen.

4. Anordnung nach Anspruch 3, **dadurch gekennzeichnet, dass** die Erzeugungsmittel (8, 9, 10) dazu ausgelegt sind, die Kopie der Regelspannung ständig zu erzeugen.

5. Anordnung nach Anspruch 3 oder 4, **dadurch gekennzeichnet, dass** das Erzeugungsmittel einen Digital-Analogwandler (8) umfasst, der mit seinem Eingang mit dem Ausgang eines Vergleichers (9) über einen logischen Schaltkreis (10) verbunden ist, wobei der Vergleicher (9) mit seinen Eingängen angeschlossen ist, um die Regelspannung des spannungsgeregelten Oszillators (1) mit der Ausgangsspannung des Digital-Analogwandlers (8) zu vergleichen.

6. Anordnung nach Anspruch 3 oder 4, **dadurch gekennzeichnet, dass** das Erzeugungsmittel einen Abtast-Halteschaltkreis umfasst, der mit seinem Eingang mit dem Ausgang eines Vergleichers verbunden ist, wobei der Vergleicher mit seinen Eingängen angeschlossen ist, um die Regelspannung des spannungsgeregelten Oszillators mit der Ausgangsspannung des Digital-Analogwandlers zu vergleichen.

## Revendications

1. Procédé de verrouillage d'une tension de commande pour un oscillateur (1) commandé en tension en correspondance avec une fréquence (f_{ref}) désirée, comportant :
- une comparaison de la fréquence (f_{vco}) de sortie de l'oscillateur (1) commandé en tension avec la fréquence (f_{ref}) désirée,
- une production d'un signal en réponse à une quelconque différence de fréquence, et
- un réglage de la tension de commande en réponse audit signal produit jusqu'à ce que la différence de fréquence soit nulle,
**caractérisé par** :
- une production d'une copie de la tension de commande, au moins lorsque ladite différence de fréquence est nulle, et
- une application de ladite copie produite de la tension de commande comme signal de commande pour l'oscillateur (1) commandé en tension afin de verrouiller sa fréquence de sortie lorsque ladite différence de fréquence est nulle.

2. Procédé selon la revendication 1, **caractérisé en ce que** ladite copie de la tension de commande est produite de façon continue.

3. Agencement destiné à verrouiller une tension de commande pour un oscillateur (1) commandé en tension en correspondance avec une fréquence (f_{ref}) désirée, comportant :
- un comparateur (7) pour comparer la fréquence (f_{vco}) de sortie de l'oscillateur (1) commandé en tension avec la fréquence (f_{ref}) désirée et pour produire un signal en réponse à une quelconque différence de fréquence, et
- un moyen (5, 6) pour régler la tension de commande en réponse audit signal produit jusqu'à ce que la différence de fréquence soit nulle, **caractérisé par** :
- un moyen (8, 9, 10) pour produire une copie de la tension de commande au moins lorsque ladite différence de fréquence est nulle, et
- un moyen (11) pour appliquer ladite copie de la tension de commande, produite lorsque ladite différence de fréquence est nulle, comme un signal de commande pour l'oscillateur (1) commandé en tension afin de verrouiller sa fréquence de sortie sur la fréquence (f_{ref}) désirée.

4. Agencement selon la revendication 3, **caractérisé par** ledit moyen (8, 9, 10) de production qui est conçu pour produire de façon continue ladite copie de la tension de commande .

5. Agencement selon la revendication 3 ou 4, **caractérisé en ce que** ledit moyen de production comporte un convertisseur (8) numérique vers analogique dont l'entrée est raccordée à la sortie d'un comparateur (9) par l'intermédiaire d'un circuit (10) logique, le comparateur (9) ayant ses entrées raccordées pour comparer la tension de commande pour l'oscillateur (1) commandé en tension avec la tension de sortie du convertisseur (8) numérique vers analogique.

6. Agencement selon la revendication 3 ou 4, **caractérisé en ce que** ledit moyen de production comporte un circuit échantillonneur-bloqueur dont les entrées sont raccordées à la sortie d'un comparateur, le comparateur ayant ses entrées raccordées pour comparer la tension de commande pour l'oscillateur commandé en tension avec la tension de sortie du circuit échantillonneur-bloqueur.
